# EUROPEAN PATENT APPLICATION

(11) **EP 3 633 738 A1**
(43) Date of publication of application: **08.04.2020**
(21) Application number: 19194036.0
(22) Date of filing: 28.08.2019
(51) Int. Cl.: H01L 31/048

(54) **SOLAR CELL MODULE, TRANSPORT, AND METHOD OF MANUFACTURING SOLAR CELL MODULE**

(30) Priority: 01.10.2018 JP 2018186694; 12.02.2019 JP 2019022381
(71) Applicant: Panasonic Intellectual Property Management Co., Ltd., Osaka-shi, Osaka 540-6207 (JP)
(72) Inventor: SHIGENO, Hiroki, Osaka-shi, Osaka 540-6207 (JP); UEDA, Takeshi, Osaka-shi, Osaka 540-6207 (JP); SUGIYAMA, Motohiko, Osaka-shi, Osaka 540-6207 (JP); TSUJI, Masashi, Osaka-shi, Osaka 540-6207 (JP)
(74) Representative: Müller-Boré & Partner Patentanwälte PartG mbB

(57) **Abstract**

A solar cell module (100) includes a front surface protective layer (10) formed from a resin, a first resin layer (20) arranged under the front surface protective layer (10), and a second resin layer (30) arranged under the first resin layer (20). The solar cell module (100) further includes a third resin layer (40) arranged under the second resin layer (30), a rear surface sealing layer (50) arranged under the third resin layer (40), and a rear surface protective layer (60) arranged under the rear surface sealing layer (50) and formed from a resin. The solar cell module (100) further includes a photoelectric converter (70) arranged between the third resin layer (40) and the rear surface sealing layer (50). The front surface protective layer (10) has a greater tensile modulus of elasticity than the first resin layer (20) and the third resin layer (40). The second resin layer (30) has a smaller tensile modulus of elasticity than the first resin layer (20) and the third resin layer (40).

## Description

### BACKGROUND

### 1. TECHNICAL FIELD

The present disclosure relates to a solar cell module, a transport, and a method of manufacturing a solar cell module.

Solar cell modules are typically mounted on roofs, for example, and are thus required to be reduced in weight. A substrate for protecting a surface of a solar cell module recently proposed is formed from a resin instead of glass.

A resin substrate has a greater coefficient of thermal expansion than a glass substrate. In order to avoid a cutoff of connectors between solar cells caused by thermal expansion or contraction of the resin substrate, a material having a small tensile modulus of elasticity has been proposed as a sealing material for a solar cell module.

International Publication WO2017/208793 discloses a solar cell module including a resin substrate, a first resin layer arranged on the resin substrate, a second resin layer arranged on the first resin layer, and a photoelectric converter arranged on the second resin layer. The solar cell module further includes a third resin layer arranged on the photoelectric converter and the second resin layer. The first resin layer has a smaller tensile modulus of elasticity than each of the resin substrate, the second resin layer, and the third resin layer.

### SUMMARY

The solar cell module disclosed in WO2017/208793 is expected to improve resistance to impact of objects such as hail, in addition to the resistance to thermal expansion or contraction of the resin substrate.

The smaller tensile modulus of elasticity of the resin layer may impede the handling of the resin layer. The handling of the resin layer thus needs to be improved, regardless of the use of the resin layer having a smaller tensile modulus of elasticity.

The improvement in the handling of the resin layer can avoid degradation in appearance of the solar cell module derived from the problem with the handling of the resin layer, leading to an improvement in productivity of the solar cell module accordingly.

To solve the above conventional problems, the present disclosure provides a solar cell module and a transport with the productivity improved.

A solar cell module according to a first aspect of the present disclosure includes a front surface protective layer formed from a resin, a first resin layer arranged under the front surface protective layer, and a second resin layer arranged under the first resin layer. The solar cell module further includes a third resin layer arranged under the second resin layer, a rear surface sealing layer arranged under the third resin layer, and a rear surface protective layer arranged under the rear surface sealing layer and formed from a resin. The solar cell module further includes a photoelectric converter arranged between the third resin layer and the rear surface sealing layer. The front surface protective layer has a greater tensile modulus of elasticity than the first resin layer and the third resin layer. The second resin layer has a smaller tensile modulus of elasticity than the first resin layer and the third resin layer.

A transport according to a second aspect of the present disclosure includes the solar cell module.

A method of manufacturing the solar cell module according to a third aspect of the present disclosure includes a first stacking step of stacking the first resin layer, the second resin layer, and the third resin layer to form a front surface sealing layer. The method of manufacturing the solar cell module further includes a second stacking step of sequentially stacking the front surface protective layer, the front surface sealing layer, the photoelectric converter, the rear surface sealing layer, and the rear surface protective layer. The method of manufacturing the solar cell module further includes a bonding step of heating a stacked body of the layers stacked in the second stacking step to bond the respective layers together.

The present disclosure can provide a solar cell module and a transport with the productivity improved.

### BRIEF DESCRIPTION OF THE DRAWINGS

Fig. 1 is a plan view illustrating an example of a solar cell module according to the present embodiment.
Fig. 2 is a cross-sectional view of the solar cell module taken along line II-II shown in Fig. 1.
Fig. 3 is a perspective view illustrating a structure of a first resin layer, a second resin layer, and a third resin layer of the solar cell module shown in Fig. 1 and Fig. 2.
Fig. 4 is a perspective view illustrating another structure of the first resin layer, the second resin layer, and the third resin layer.
Fig. 5 is a perspective view illustrating still another structure of the first resin layer, the second resin layer, and the third resin layer.
Fig. 6 is a perspective view illustrating still another structure of the first resin layer, the second resin layer, and the third resin layer.
Fig. 7 is a cross-sectional view taken along line VII-VII shown in Fig. 6.
Fig. 8 is a cross-sectional view illustrating another example of the solar cell module according to the present embodiment.
Fig. 9 is a cross-sectional view illustrating still another example of the solar cell module according to the present embodiment.
Fig. 10 is a cross-sectional view illustrating an example of a method of manufacturing the solar cell module according to the present embodiment.
Fig. 11 is a photograph showing an external appearance of a solar cell module obtained in Example 1.
Fig. 12 is a photograph showing an external appearance of a solar cell module obtained in Example 2.
Fig. 13 is a photograph showing an external appearance of a solar cell module obtained in Example 3.
Fig. 14 is a photograph showing an external appearance of a solar cell module obtained in Comparative Example 1.

### DETAILED DESCRIPTION

A solar cell module, a transport, and a method of manufacturing a solar cell module according to the present embodiment are described in detail below with reference to the drawings. The dimensions of elements in the drawings may be exaggerated for illustration purposes, and are not necessarily drawn to scale.

### [Solar cell module]

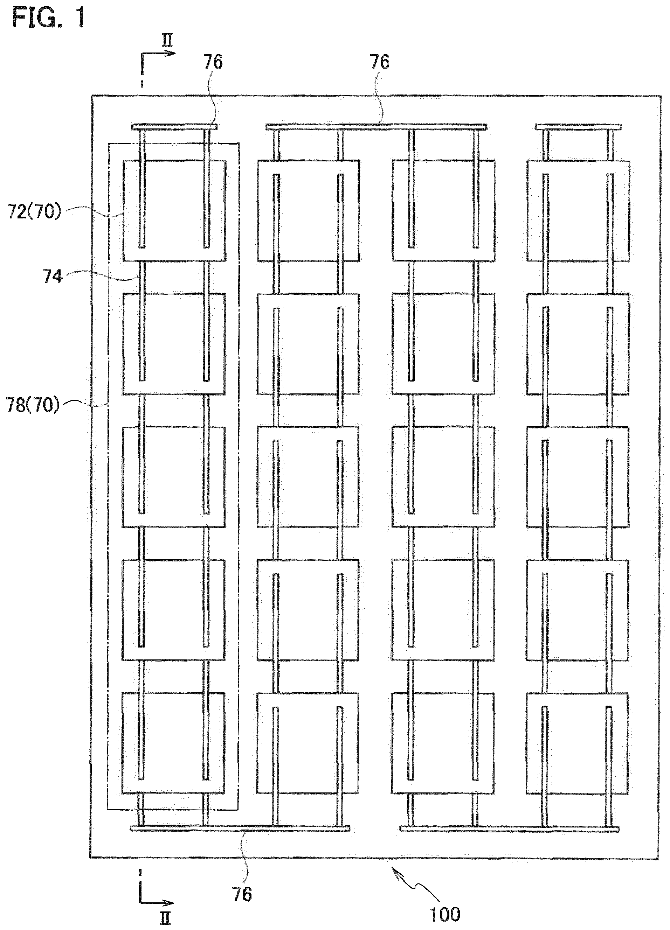

Fig. 1 is a plan view illustrating an example of the solar cell module 100 according to the present embodiment. As shown in Fig. 1, the solar cell module 100 includes a photoelectric converter 70. The photoelectric converter 70 converts radiated light into electrical energy due to the photovoltaic effect. The photoelectric converter 70 maybe either an individual solar cell 72 or a solar cell string 78.

The respective pairs of the solar cell strings 78 arranged in parallel are electrically connected to each other via connectors 76. Each of the solar cell strings 78 includes the solar cells 72 and connectors 74.

Fig. 1 illustrates a case in which the five solar cells 72 aligned in one direction are connected in series via the connectors 74 so as to compose the single solar cell string 78. As shown in Fig. 1, the four solar cell strings 78 are electrically connected to each other via the connectors 76 in the direction substantially perpendicular to the connected direction of the five solar cells 72. The number of the solar cells 72 and the number of the solar cell strings 78 in the respective directions are not limited to the illustration of the present embodiment.

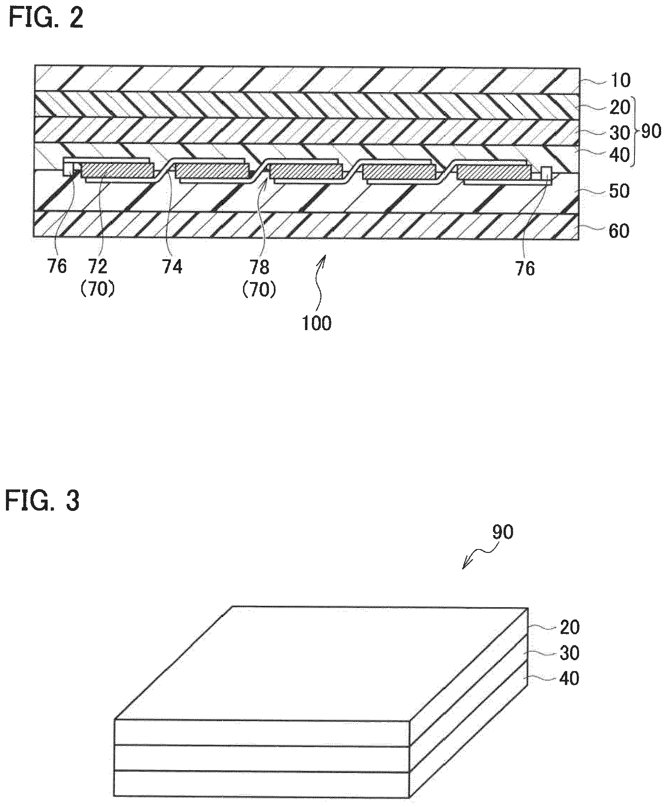

Fig. 2 is a cross-sectional view of the solar cell module 100 taken along line II-II shown in Fig. 1. The solar cell module 100 according to the present embodiment includes a front surface protective layer 10, a first resin layer 20, a second resin layer 30, a third resin layer 40, a rear surface sealing layer 50, a rear surface protective layer 60, and the photoelectric converter 70. These layers may be in contact with each other, or another layer may be interposed between the respective layers. The respective constituent elements are described in detail below.

### <Front surface protective layer>

The front surface protective layer 10 may be provided on the light-receiving surface side of the respective solar cells 72. The front surface protective layer 10 protects the surface of the solar cell module 100 on the light-receiving surface side. The front surface protective layer 10 may be provided on the outermost surface of the solar cell module 100 on the light-receiving surface side, or another layer may further be provided on the surface of the front surface protective layer 10 on the light-receiving surface side. As used herein, the term "light-receiving surface" refers to a surface of the respective solar cells 72 on which light is mainly incident, receiving the larger amount of incident light per unit area than the rear surface.

The front surface protective layer 10 is formed from a resin. The solar cell module 100 thus achieves a reduction in weight, as compared with a case of a material formed from glass, for example. The reduction in weight of the solar cell module 100 can reduce a load applied to an installation part such as a roof on which the solar cell module 100 is mounted, expanding the possibility of location of the solar cell module 100 to be installed.

The resin used for forming the front surface protection layer 10 may be transparent to light. A total luminous transmittance of the front surface protective layer 10 is preferably set in a range of 80% to 100%, and more preferably in a range of 85% to 100%. The front surface protective layer 10 with the total luminous transmittance set in the above range enables light to reach the solar cells 72 efficiently. The total luminous transmittance in the present specification may be measured by a method prescribed in Japanese Industrial Standards JIS K7361-1 (Plastics-Determination of the total luminous transmittance of transparent materials-Part 1: Single beam instrument), for example.

The front surface protective layer 10 has a greater tensile modulus of elasticity than the first resin layer 20 and the third resin layer 40. The front surface protective layer 10 with the greater tensile modulus of elasticity can sufficiently protect the solar cell module 100 against impact of objects, for example. The tensile modulus of elasticity is also preferably greater for the front surface protective layer 10 than for the rear surface sealing layer 50. In particular, the tensile modulus of elasticity of the front surface protective layer 10 is preferably set in a range of 1.0 GPa or greater and 10.0 GPa or less, and more preferably in a range of 2.3 GPa or greater and 2.5 GPa or less. The tensile modulus of elasticity in the present specification may be measured in accordance with JIS K7161-1 (Plastics-Determination of tensile properties-Part 1: General principles) under the conditions of a test temperature of 25°C and a test velocity of 100 mm per minute.

A coefficient of linear expansion is preferably smaller for the front surface protective layer 10 than for the first resin layer 20. The coefficient of linear expansion is also preferably smaller for the front surface protective layer 10 than for the second resin layer 30. The coefficient of linear expansion is also preferably smaller for the front surface protective layer 10 than for the third resin layer 40. The coefficient of linear expansion is also preferably smaller for the front surface protective layer 10 than the rear surface sealing layer 50. The coefficient of linear expansion in the present specification maybe measured in accordance with JIS K7197:2012 (Testing method for linear thermal expansion coefficient of plastics by thermomechanical analysis).

The resin used for forming the front surface protective layer 10 preferably includes at least one resin selected from the group consisting of polyester such as polyethylene terephthalate (PET), polybutylene terephthalate (PBT), and polyethylene naphthalate (PEN), polycarbonate (PC), amorphous polyarylate, polyacetal (POM), polyether ketone (PEK), polyether ether ketone (PEEK), polyethersulfone, and modified-polyphenyleneether. The resin used for the front surface protective layer 10 is particularly preferably polycarbonate (PC) having higher resistance to impact and higher transmittance.

A thickness of the front surface protective layer 10 is preferably set in a range of 0.1 mm to 100 mm, more preferably in a range of 0.1 mm to 50 mm, and still more preferably in a range of 0.5 mm to 10 mm. The front surface protective layer 10 with the thickness set in the above range can protect the solar cell module 100 against impact of objects, and enable light to reach the solar cells 72 efficiently.

### <First resin layer>

The first resin layer 20 is arranged under the front surface protective layer 10. In particular, the first resin layer 20 is interposed between the front surface protective layer 10 and the second resin layer 30. The first resin layer 20 may be in direct contact with the front surface protective layer 10, or may be bonded to the front surface protective layer 10 via any other layer such as a bonding layer.

A thickness of the first resin layer 20 is preferably, but not necessarily, set in a range of 0.01 mm or greater and 10 mm or less, more preferably in a range of 0.01 mm or greater and 1.0 mm or less, and still more preferably in a range of 0.01 mm or greater and 0.6 mm or less. The first resin layer 20 with the thickness set in the above range can protect the solar cells 72 sufficiently, and enable light to reach the solar cells 72 efficiently.

The thickness is preferably smaller for the first resin layer 20 than for the third resin layer 40. Such a configuration can avoid a cutoff of the connectors between the respective solar cells 72 if the front surface protective layer 10 expands or contracts due to a variation in temperature. Preferably, the thickness of the first resin layer 20 is set in a range of 0.01 mm to 1.0 mm, and the thickness of the third resin layer 40 is set in a range of 0.1 mm to 2.0 mm. More preferably, the thickness of the first resin layer 20 is set in a range of 0.01 mm to 0.6 mm, and the thickness of the third resin layer 40 is set in a range of 0.3 mm to 0.6 mm.

The first resin layer 20 preferably has a smaller tensile modulus of elasticity than the rear surface protective layer 60. In particular, the tensile modulus of elasticity of the first resin layer 20 is preferably set in a range of 5 MPa or greater and less than 1 GPa, and more preferably in a range of 10 MPa or greater and less than 500 MPa. The first resin layer 20 with the tensile modulus of elasticity set in the above range can protect the solar cells 72 against external impact effectively.

A total luminous transmittance of the first resin layer 20 is preferably, but not necessarily, set in a range of 60% to 100%, more preferably in a range of 70% to 100%, and still more preferably in a range of 80% to 100%. The first resin layer 20 with the total luminous transmittance set in the above range enables light to reach the solar cells 72 efficiently.

A material used for forming the first resin layer 20 preferably includes a thermoplastic resin and a thermosetting resin, for example. These resins may be either a modified resin or an unmodified resin. For the thermoplastic resin, the material preferably includes at least one resin selected from the group consisting of an ethylene-vinyl acetate copolymer (EVA), an olefin resin, polyvinyl butyral (PVB), polyethylene terephthalate (PET), and polyimide (PI). For the thermosetting resin, the material preferably includes at least one resin selected from the group consisting of epoxy, urethane, and polyimide.

The material used for forming the first resin layer 20 is more preferably the thermoplastic resin, and particularly preferably at least either the ethylene-vinyl acetate copolymer (EVA) copolymer or the olefin resin, in view of the protection of the solar cells 72.

Examples of olefin resins include a polyolefin and a thermoplastic polyolefinic elastomer (TPO). The thermoplastic polyolefinic elastomer (TPO) includes a polyolefin and typical rubber mixed together. A rubber phase of the thermoplastic polyolefinic elastomer (TPO) may have no crosslinking point or have less crosslinking points.

Examples of polyolefin include a homopolymer of α-olefin such as ethylene, propylene, 1-butene, 1-pentene, 1-hexene, 4-methyl-1-pentene, 1-octene, or 1-decene, and a copolymer of these compounds.

Examples of rubbers used for the thermoplastic polyolefinic elastomer (TPO) include natural rubber (NR), isoprene rubber (IR), butadiene rubber (BR), styrenebutadiene rubber (SBR), acrylonitrile-butadiene rubber (NBR), chloroprene rubber (CR), butyl rubber (IIR), ethylene-propylene rubber (EPM), and ethylene-propylene-diene rubber (EPDM).

### <Second resin layer>

The second resin layer 30 is arranged under the first resin layer 20. In particular, the second resin layer 30 is interposed between the first resin layer 20 and the third resin layer 40. The second resin layer 30 may be in direct contact with the first resin layer 20, or may be bonded to the first resin layer 20 via any other layer such as a bonding layer.

According to the present embodiment, the tensile modulus of elasticity is smaller for the second resin layer 30 than for the first resin layer 20 and the third resin layer 40. The second resin layer 30 with the smaller tensile modulus of elasticity than these layers can function as a buffer material, so as to not only deal with thermal expansion or contraction of the front surface protective layer 10 but also improve the resistance to impact of objects such as hail. The tensile modulus of elasticity may be smaller for the second resin layer 30 than for the rear surface sealing layer 50, and may be smaller for the second resin layer 30 than for the rear surface protective layer 60.

The tensile modulus of elasticity of the second resin layer 30 is preferably set in a range of 0.1 kPa or greater and less than 0.5 MPa. The second resin layer 30 with the tensile modulus of elasticity set in the above range can effectively protect the solar cells 72 against external impact to stably keep the shape. The tensile modulus of elasticity of the second resin layer 30 is more preferably set to 1 kPa or greater, and still more preferably set to 10 kPa or greater, in order to keep the shape more stably and reliably. The tensile modulus of elasticity of the second resin layer 30 is preferably set to 300 kPa or less, and more preferably set to 100 kPa or less, in order to improve the impact-buffering properties.

A material used for forming the second resin layer 30 preferably, but not necessarily, includes various types of gel. The content of gel included in the second resin layer 30 is preferably set to 50% or greater, more preferably 80% or greater, and still more preferably 90% or greater. The gel can be classified into a gel containing a solvent and a gel not containing a solvent, for example. An example of the gel containing a solvent may be a hydrogel in which water is a dispersion medium, or an organogel in which an organic solvent is a dispersion medium. The gel containing a solvent may also be any of a polymer gel with a number-average molecular weight of 10,000 or greater, an oligomer gel with a number-average molecular weight in a range of 1,000 or greater and less than 10,000, and a low molecular weight gel with a number-average molecular weight of less than 1,000. The material used for forming the second resin layer 30 particularly preferably includes the polymer gel containing a solvent or the gel not containing a solvent. Among these gels, the material used for forming the second resin layer 30 preferably includes at least one gel selected from the group consisting of a silicone gel, an acrylic gel, and a urethane gel. These gels have a smaller tensile modulus of elasticity and a higher effect of protecting the solar cells 72 against external impact.

A thickness of the second resin layer 30 is preferably, but not necessarily, set in a range of 0.05 mm or greater and 10 mm or less, and more preferably in a range of 0.1 mm or greater and 1.0 mm or less. The second resin layer 30 with the thickness set in the above range can protect the photoelectric converter 70 sufficiently, and enable light to reach the photoelectric converter 70 efficiently.

A total luminous transmittance of the second resin layer 30 is preferably, but not necessarily, set in a range of 60% to 100%, and more preferably in a range of 70% to 100%. The total luminous transmittance of the second resin layer 30 is still more preferably set in a range of 80% to 100%. The second resin layer 30 with the total luminous transmittance set in the above range enables light to reach the photoelectric converter 70 efficiently.

### <Third resin layer>

The third resin layer 40 is arranged under the second resin layer 30. In particular, the third resin layer 40 is interposed between the second resin layer 30 and the rear surface sealing layer 50. The third resin layer 40 may be in direct contact with the second resin layer 30, or may be bonded to the second resin layer 30 via any other layer such as a bonding layer.

The third resin layer 40 may have a configuration identical to that of the first resin layer 20. In particular, the third resin layer 40 may have a configuration including the thickness, the tensile modulus of elasticity, the total luminous transmittance, and the material to be used, which are identical to those for the first resin layer 20 described above. The third resin layer 40 does not necessarily have the same configuration as the first resin layer 20, and may have a different configuration.

### <Rear surface sealing layer>

The rear surface sealing layer 50 is arranged under the third resin layer 40. In particular, the rear surface sealing layer 50 is interposed between the third resin layer 40 and the rear surface protective layer 60. The rear surface sealing layer 50 may be in direct contact with the third resin layer 40, or may be bonded to the third resin layer 40 via any other layer such as a bonding layer.

The rear surface sealing layer 50 may have a configuration identical to that of each of the first resin layer 20 and the third resin layer 40. In particular, the rear surface sealing layer 50 may have a configuration including the thickness, the tensile modulus of elasticity, the total luminous transmittance, and the material to be used, which are identical to those for each of the first resin layer 20 and the third resin layer 40 described above. The rear surface sealing layer 50 does not necessarily have the same configuration as the first resin layer 20, and may have a different configuration. The rear surface sealing layer 50 does not necessarily have the same configuration as the third resin layer 40, and may have a different configuration.

### <Rear surface protective layer>

The rear surface protective layer 60 is arranged under the rear surface sealing layer 50. The rear surface protective layer 60 may be in direct contact with the rear surface sealing layer 50, or may be bonded to the rear surface sealing layer 50 via any other layer such as a bonding layer. The rear surface protective layer 60 can be provided on the opposite side of the light-receiving surface of the respective solar cells 72. The rear surface protective layer 60 arranged on the opposite side (the rear side) of the light-receiving surface of the solar cell module 100 protects the rear surface side of the solar cell module 100. The rear surface protective layer 60 may be provided on the outermost surface of the solar cell module 100 on the rear surface side, or another layer may further be provided on the surface of the rear surface protective layer 60 on the rear surface side.

The rear surface protective layer 60 is formed from a resin. The solar cell module 100 thus achieves a reduction in weight, as compared with a case of a material formed from metal, for example. The reduction in weight of the solar cell module 100 can reduce a load applied to an installation part such as a roof on which the solar cell module 100 is mounted, expanding the possibility of location of the solar cell module 100 to be installed.

The resin used for forming the rear surface protective layer 60 preferably includes at least one resin selected from the group consisting of polyimide (PI), cyclic polyolefin, polycarbonate (PC), polymethyl methacrylate (PMMA), polyether ether ketone (PEEK), polystyrene (PS), polyethylene terephthalate (PET), polyethylene naphthalate (PEN), and fiber-reinforced plastic (FRP). The resin used for the rear surface protective layer 60 is particularly preferably fiber-reinforced plastic (FRP) in view of sufficient strength and a reduction in weight.

The fiber-reinforced plastic (FRP) is preferably at least one plastic selected from the group consisting of glass fiber-reinforced plastic (GFRP), carbon fiber-reinforced plastic (CFRP), aramid fiber-reinforced plastic (AFRP), and cellulose fiber-reinforced plastic, for example. The resin used for the rear surface protective layer 60 is particularly preferably carbon fiber-reinforced plastic which is resistant to warping and has a lighter weight.

The rear surface protective layer 60 preferably has at least a structure selected from the group consisting of a honeycomb structure, a foamed body, and a porous body. These structures can contribute to a reduction in weight of the solar cell module 100 while sufficiently keeping the rigidity of the solar cell module 100.

The thickness of the rear surface protective layer 60 is preferably, but not necessarily, set in a range of 0.1 mm to 10 mm, and more preferably in a range of 0.1 mm to 5.0 mm. The rear surface protective layer 60 with the thickness set in the above range can avoid warping, and further contribute to a reduction in weight of the solar cell module 100.

The tensile modulus of elasticity of the rear surface protective layer 60 is preferably, but not necessarily, set in a range of 1 GPa or greater and 50 GPa or less, and more preferably in a range of 20 GPa or greater and 30 GPa or less. The rear surface protective layer 60 with the tensile modulus of elasticity set in the above range can improve the rigidity of the solar cell module 100.

The coefficient of linear expansion is preferably smaller for the rear surface protective layer 60 than for the front surface protective layer 10. The coefficient of linear expansion is also preferably smaller for the rear surface protective layer 60 than for the first resin layer 20, the third resin layer 40, and the rear surface sealing layer 50. The coefficient of linear expansion is also preferably smaller for the rear surface protective layer 60 than for the second resin layer 30. In particular, the coefficient of linear expansion of the rear surface protective layer 60 is preferably set to 70 × 10⁻⁶ K⁻¹ or less, more preferably 50 × 10⁻⁶ K⁻¹ or less, and still more preferably 20 × 10⁻⁶ K⁻¹ or less.

### <Photoelectric converter>

The photoelectric converter 70 is arranged between the third resin layer 40 and the rear surface sealing layer 50. In particular, the photoelectric converter 70 is sealed by the third resin layer 40 and the rear surface sealing layer 50. The sealed photoelectric converter 70 can be protected against external impact. As described above, the photoelectric converter 70 may be either the individual solar cell 72 or the solar cell string 78.

As shown in Fig. 2, the solar cell strings 78 each include the solar cells 72 and the connectors 74. The respective adjacent solar cells 72 are connected to each other via the connectors 74. In particular, each of the aligned solar cells 72 on the light-receiving surface side is electrically connected to its adjacent solar cell 72 on the rear side via the connectors 74.

The solar cells 72 may be conventionally-known solar cells having a right-receiving surface and a rear surface on the opposite side of the light-receiving surface. The shape of the solar cells 72 is determined as appropriate, and may have a flat shape or a concave shape curved in a direction vertical to the plane direction.

The solar cells 72 may each be a silicon solar cell, a compound-based solar cell, and an organic solar cell, for example. Examples of silicon solar cells include a monocrystalline silicon solar cell, a polycrystalline silicon solar cell, a microcrystalline silicon solar cell, and an amorphous silicon solar cell. Examples of compound-based solar cells include a GaAs solar cell, a CIS solar cell, a CIGS solar cell, and a CdTe solar cell. Examples of organic solar cells include a dye-sensitized solar cell and an organic thin-film solar cell. Other examples of the solar cells 72 include a heterojunction solar cell and a multi-junction solar cell.

Although not shown, the solar cells 72 may each include a current collector electrode including a plurality of finger electrodes extending substantially parallel to each other, and a plurality of busbar electrodes extending in a direction substantially perpendicular to the extending direction of the finger electrodes. According to the present embodiment, the busbar electrodes on the light-receiving surface side of each of the aligned solar cells 72 are electrically connected to the busbar electrodes on the rear side of its adjacent solar cell 72 via the connectors 74.

The connectors 74 or the connectors 76 may have any shape or may include any material that can electrically connect the respective adjacent solar cells 72 or the respective adjacent solar cell strings 78 together, and may be made of a long narrow metal foil. The material used for forming the connectors 74 is preferably metal such as copper, for example. The connectors 74 may include a cover layer covering the metal such as copper. The cover layer may be provided by soldering or by use of silver.

The connectors 74 and the busbar electrodes may be connected together with resin. The resin may be either conductive or nonconductive. For the nonconductive resin, the connectors 74 and the busbar electrodes are directly connected to each other to achieve electrical connection. Alternatively, the connectors 74 and the busbar electrodes may be connected by soldering, instead of resin.

The configuration of the first resin layer 20, the second resin layer 30, and the third resin layer 40 is described below. Fig. 3 is a perspective view illustrating the structure of the first resin layer 20, the second resin layer 30, and the third resin layer 40 in the solar cell module 100 shown in Fig. 1 and Fig. 2. According to the present embodiment, the second resin layer 30, which is relatively difficult to handle, is sandwiched between the first resin layer 20 and the third resin layer 40. In particular, the second resin layer 30 is interposed between the first resin layer 20 and the third resin layer 40 each having a greater tensile modulus of elasticity than the second resin layer 30.

The first resin layer 20 and the third resin layer 40 function as a support member for supporting the second resin layer 30. The first resin layer 20, the second resin layer 30, and the third resin layer 40 thus can integrally function as a front surface sealing layer 90 having rigidity. This structure facilitates the handling of the second resin layer 30 having a smaller tensile modulus of elasticity. The improvement in the handling of the second resin layer 30 further facilitates the manufacture of the solar cell module 100, so as to avoid degradation in appearance of the solar cell module 100 caused by bubbles entering between the front surface protective layer 10 and the front surface sealing layer 90, for example. The productivity of the solar cell module 100 thus can be improved accordingly.

Fig. 3 illustrates the case in which the first resin layer 20 and the third resin layer 40 are not in direct contact with each other with the second resin layer 30 interposed therebetween. The circumferential edge of the second resin layer 30 in this case is completely exposed to the outside.

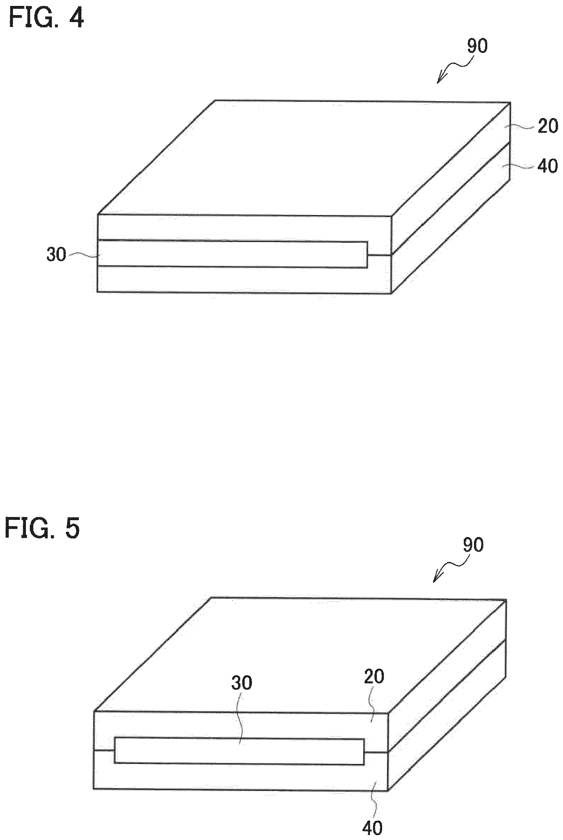

Fig. 4 is a perspective view illustrating another example of the structure of the first resin layer 20, the second resin layer 30, and the third resin layer 40. As shown in Fig. 4, the first resin layer 20 and the third resin layer 40 may be bonded to each other at least partly at the circumferential edge of the second resin layer 30. In particular, at least either the first resin layer 20 or the third resin layer 40 may cover part of the circumferential edge of the second resin layer 30 so as to isolate the second resin layer 30 from the outside of the solar cell module 100 in the direction perpendicular to the thickness direction of the second resin layer 30. This structure reduces the exposure of the second resin layer 30, so as to avoid a problem of causing the second resin layer 30 to project through the gap between the first resin layer 20 and the third resin layer 40. The handling of the second resin layer 30 thus can be improved, and the reproducibility of finished products can also be enhanced. The productivity of the solar cell module 100 thus can be further improved accordingly.

The first resin layer 20 and the third resin layer 40 are bonded by a method determined as appropriate, and may be bonded with an adhesive or by heating and pressure bonding. The heating and pressure bonding is preferable so as to facilitate the bonding therebetween.

When the second resin layer 30 has a substantially polygonal shape as viewed in the thickness direction, the outer peripheral surface of the second resin layer 30 at least on one side of the polygon is preferably covered with at least either the first resin layer 20 or the third resin layer 40. As used herein, the term "polygon" is not necessarily a strict polygonal shape. For example, the corners of the polygon may be rounded off.

For example, as shown in Fig. 4, when the second resin layer 30 has a substantially rectangular shape as viewed in the thickness direction, the outer peripheral surface of the second resin layer 30 on one side of the rectangle may be covered with the first resin layer 20 and the third resin layer 40. While Fig. 4 illustrates the case in which one of the sides is covered, two of the sides, or three or more sides of the substantially polygonal shape may be covered with the first resin layer 20 and the third resin layer 40.

For example, as shown in Fig. 5, when the second resin layer 30 has a substantially rectangular shape as viewed in the thickness direction, the outer peripheral surface of the second resin layer 30 on the two opposed sides of the rectangle may be covered with the first resin layer 20 and the third resin layer 40. The rectangle shown in Fig. 5 has the same configuration on both of the front and back sides, in which the second resin layer 30 is also exposed to the outside on the back side.

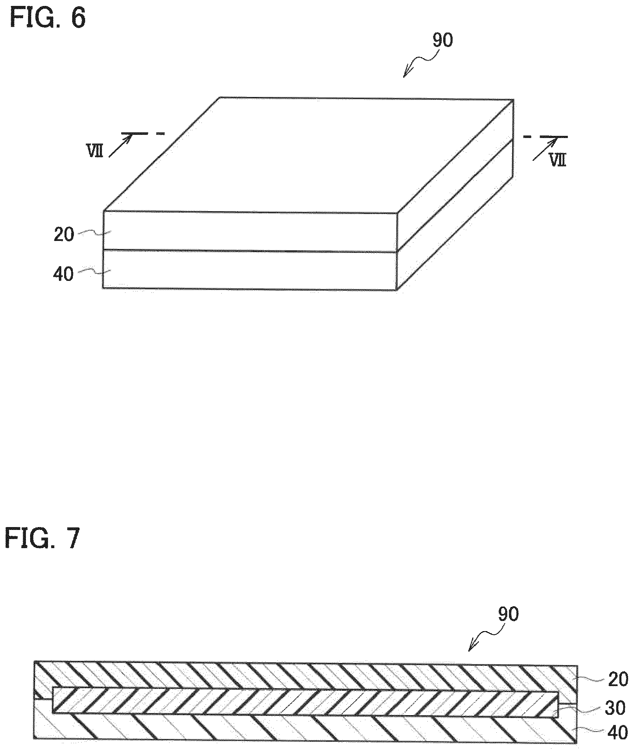

Fig. 6 is a perspective view illustrating still another example of the structure of the first resin layer 20, the second resin layer 30, and the third resin layer 40. Fig. 7 is a cross-sectional view taken along line VII-VII shown in Fig. 6. The entire circumferential edge of the second resin layer 30 is preferably surrounded by the first resin layer 20 and the third resin layer 40, as shown in Fig. 6 and Fig. 7. Namely, the outer peripheral surface of the second resin layer 30 is preferably completely covered with the first resin layer 20 and the third resin layer 40. In particular, as shown in Fig. 6, when the second resin layer 30 has a substantially rectangular shape as viewed in the thickness direction, the outer peripheral surface of the second resin layer 30 on all the sides of the rectangle maybe covered with the first resin layer 20 and the third resin layer 40. The rectangle shown in Fig. 6 has the same configuration on both of the front and back sides, in which the second resin layer 30 is not exposed to the outside on the back side either.

The structure shown in Fig. 6 can prevent the second resin layer 30 from projecting through the gap between the first resin layer 20 and the third resin layer 40, since the second resin layer 30 is not exposed to the outside. The handling of the second resin layer 30 thus can be improved, and the reproducibility of finished products can also be enhanced, further improving the productivity of the solar cell module 100 accordingly.

The proportion of the exposed area of the second resin layer 30 in the direction perpendicular to the thickness direction is preferably set to 75% or less, more preferably 50% or less, still more preferably 25% or less, particularly preferably 10% or less, and most preferably 1% or less. The smaller proportion of the exposed area of the second resin layer 30 can prevent the second resin layer 30 from projecting through the gap between the first resin layer 20 and the third resin layer 40, so as to facilitate the handling of the second resin layer 30. The proportion of the exposed area of the second resin layer 30 is a percentage of the exposed area to the entire area of the outer peripheral surface of the second resin layer 30 in the direction perpendicular to the thickness direction. For example, the proportion of the exposed area of the second resin layer 30 is approximately 100% in the structure shown in Fig. 3, approximately 75% in the structure shown in Fig. 4, approximately 50% in the structure shown in Fig. 5, and approximately 0% in the structure shown in Fig. 6 and Fig. 7.

The second resin layer 30 is preferably partly in direct contact with the front surface protective layer 10. The second resin layer 30 is also preferably partly in direct contact with the photoelectric converter 70. The second resin layer 30 is also preferably partly in direct contact with the rear surface sealing layer 50. For example, providing at least either the first resin layer 20 or the third resin layer 40 with penetration holes can achieve the solar cell module 100 having such a configuration. The above structure can facilitate the removal of bubbles caused during the manufacture of the solar cell module 100 through the penetration holes provided in the first resin layer 20 or the third resin layer 40. The structure provided with the penetration holes also allows the first resin layer 20 or the third resin layer 40 to easily follow expansion deformation of the second resin layer 30 caused during heating and molding, so as to manufacture the solar cell module 100 with less undulation, providing the solar cell module 100 having favorable appearance accordingly.

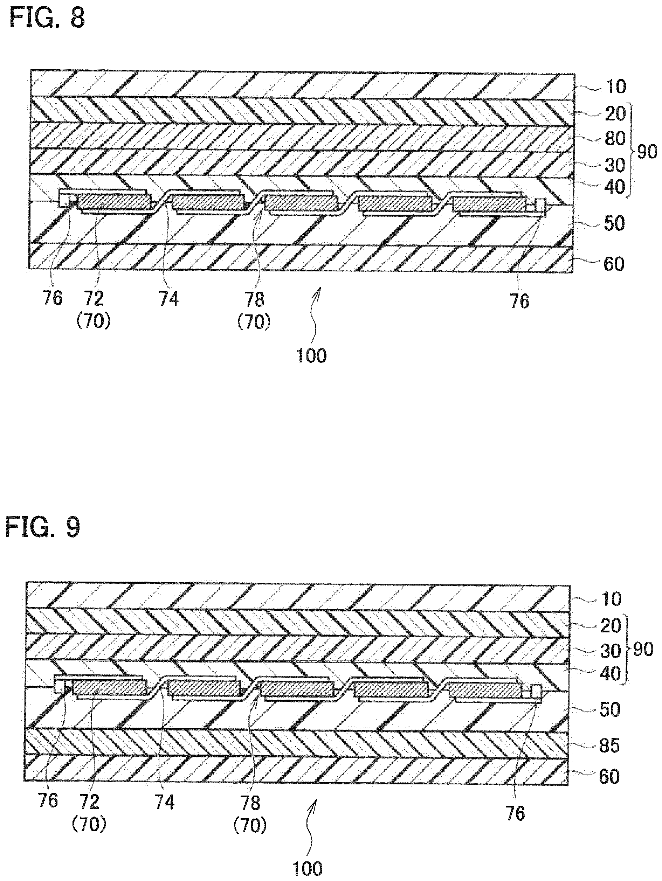

Fig. 8 is a cross-sectional view illustrating another example of the solar cell module 100 according to the present embodiment. As shown in Fig. 8, the solar cell module 100 may further include a first barrier layer 80 arranged at least on one surface of the second resin layer 30, and having at least either a smaller oxygen transmission rate or a smaller water vapor transmission rate than the front surface protective layer 10.

While Fig. 8 illustrates the case in which the first barrier layer 80 is interposed between the first resin layer 20 and the second resin layer 30, the first barrier layer 80 may be interposed between the second resin layer 30 and the third resin layer 40 instead. The first barrier layer 80 may be provided between the first resin layer 20 and the second resin layer 30, and between the second resin layer 30 and the third resin layer 40. The first barrier layer 80 may be included in the front surface sealing layer 90.

Fig. 9 is a cross-sectional view illustrating still another example of the solar cell module 100 according to the present embodiment. As shown in Fig. 9, the solar cell module 100 may further include a second barrier layer 85 arranged between the rear surface sealing layer 50 and the rear surface protective layer 60, and having at least either a smaller oxygen transmission rate or a smaller water vapor transmission rate than the rear surface protective layer 60.

The inclusion of at least either the first barrier layer 80 or the second barrier layer 85 in the solar cell module 100 can enhance the long-term reliability of the solar cell module 100. The configurations of the first barrier layer 80 and the second barrier layer 85 described below may be common to each other or may differ from each other.

The oxygen transmission rate of the first barrier layer 80 and the second barrier layer 85 is preferably set to 200 cm³/m²·24h·atm or less, and more preferably in a range of 0.001 to 200 cm³/m²·24h·atm. The oxygen transmission rate of the first barrier layer 80 and the second barrier layer 85 set in the above range can decrease the content of oxygen entering the photoelectric converter 70 to prevent and reduce the degradation of the photoelectric converter 70. The oxygen transmission rate in the present specification may be measured in accordance with the prescription described in JIS K7126-2 (Plastics-Film and sheeting-Determination of gas-transmission rate-Part 2: Equal-pressure method). The oxygen transmission rate may be measured under the conditions of a measurement temperature of 23°C and a measurement humidity of 90% RH.

The water vapor transmission rate of the first barrier layer 80 and the second barrier layer 85 is preferably set in a range of greater than 0 g/(m²·day) and 0.1 g/(m²·day) or less. The water vapor transmission rate of the first barrier layer 80 and the second barrier layer 85 set in the above range can decrease the content of moisture entering the photoelectric converter 70 to prevent and reduce the degradation of the photoelectric converter 70. The water vapor transmission rate in the present specification may be measured by an infrared sensing method prescribed in Appendix B to JIS K7129:2008 (Plastics-Film and sheeting-Determination of water vapour transmission rate-Instrumental method), for example. The water vapor transmission rate may be measured under the conditions of a measurement temperature of 40°C and a measurement humidity of 90% RH.

The first barrier layer 80 and the second barrier layer 85 preferably, but not necessarily, have a thickness set in a range of 0.01 mm or greater and 1.0 mm or less, more preferably in a range of 0.05 mm or greater and 0.5 mm or less, and still more preferably in a range of 0.1 mm or greater and 0.3 mm or less. Setting the thickness in the above range can sufficiently keep the barrier properties while avoiding an increase in cost.

A material used for forming the first barrier layer 80 and the second barrier layer 85 preferably includes at least one compound selected from the group consisting of polyvinyl chloride (PVC), polyethylene terephthalate (PET), cast nylon (CNY), biaxially oriented nylon (ONY), polyvinylidene chloride (PVDC)-coated biaxially oriented polypropylene (OPP), polyvinylidene chloride (PVDC)-coated biaxially oriented nylon (ONY), poly(meta-xylylene adipamide) (nylon MXD6), ethylene-vinylalcohol copolymer (EVOH), vinylidene chloride-methyl acrylate copolymer, alumina-coated PET, silica-coated PET, and nano-composite-coated PET.

The solar cell module 100 according to the present embodiment may be mounted on a roof of a construction or a transport, for example. The solar cell module 100 may have a curved shape so as to be fitted for a roof. The front surface protective layer 10 may have a shape convex and curved toward the light-receiving surface side. The solar cell module 100 and the front surface protective layer 10 may have an arc-like shape convex toward the light-receiving surface side, for example.

The solar cell module 100 according to the present embodiment includes the front surface protective layer 10 formed from a resin, the first resin layer 20 arranged under the front surface protective layer 10, and the second resin layer 30 arranged under the first resin layer 20. The solar cell module 100 further includes the third resin layer 40 arranged under the second resin layer 30, the rear surface sealing layer 50 arranged under the third resin layer 40, and the rear surface protective layer 60 arranged under the rear surface sealing layer 50 and formed from a resin. The solar cell module 100 further includes the photoelectric converter 70 arranged between the third resin layer 40 and the rear surface sealing layer 50. The front surface protective layer 10 has a greater tensile modulus of elasticity than the first resin layer 20 and the third resin layer 40. The second resin layer 30 has a smaller tensile modulus of elasticity than the first resin layer 20 and the third resin layer 40.

As described above, the second resin layer 30 with the smaller tensile modulus of elasticity than the other layers functions as a buffer material, so as to not only deal with the thermal expansion or contraction of the front surface protective layer 10 but also improve the resistance to impact of objects such as hail.

The first resin layer 20, the second resin layer 30, and the third resin layer 40 can integrally function as the front surface sealing layer 90 having rigidity so as to seal the photoelectric converter 70. This structure facilitates the handling of the second resin layer 30 having a smaller tensile modulus of elasticity. The improvement in the handling of the second resin layer 30 further facilitates the manufacture of the solar cell module 100, so as to avoid degradation in appearance of the solar cell module 100. The productivity of the solar cell module 100 thus can be improved accordingly.

### [Transport]

As described above, the solar cell module 100 according to the present embodiment may be mounted on a roof of a transport. In particular, the transport according to the present embodiment includes the solar cell module 100. Examples of transports include a vehicle such as an automobile, a train, and a ship. For the automobile, the solar cell module 100 according to the present embodiment is preferably mounted on a top surface of a body of the automobile such as a hood or a roof. A current generated by the solar cell module 100 according to the present embodiment in any type of transport is supplied to an electrical device, such as a fan and a motor, so as to drive or control the electrical device.

### [Method of manufacturing solar cell module]

A method of manufacturing the solar cell module 100 according to the present embodiment is described below. The method of manufacturing the solar cell module 100 according to the present embodiment includes a first stacking step, a second stacking step, and a bonding step. The respective steps are described in detail below.

### <First stacking step>

The first stacking step is to prepare the front surface sealing layer 90 including the first resin layer 20, the second resin layer 30, and the third resin layer 40. In the first stacking step, the first resin layer 20, the second resin layer 30, and the third resin layer 40 are stacked so as to form the front surface sealing layer 90.

The stacking method for preparing the front surface sealing layer 90 is determined as appropriate. For example, the material used for the second resin layer 30 may be applied to the surface of either the first resin layer 20 or the third resin layer 40. The method of applying the material used for the second resin layer 30 is determined as appropriate. An example of the method of applying the material is painting or printing. For the painting, a paint composition may be applied by use of an air spray, a brush, a bar coater, a Meyer bar, or an air knife. The paint composition may also be applied by spin coating. Examples of printing include gravure printing, reverse gravure printing, offset printing, flexographic printing, and screen printing.

As another example of the stacking method for preparing the front surface sealing layer 90, a sheet used for forming the second resin layer 30 may be attached to the surface of either the first resin layer 20 or the third resin layer 40. The method of attaching the sheet used for forming the second resin layer 30 may be a conventionally-known method, such as a method of pressure bonding with heat, or a method of bonding by use of adhesiveness of the second resin layer 30. When any material used in the respective layers is cross-linked by heating, the second resin layer 30 is preferably bonded by pressure while being heated at a temperature not causing cross-linking, or is preferably bonded by use of the adhesiveness of the second resin layer 30, in order to keep the adhesion between the respective layers in the bonding step described below.

Subsequently, the applied or attached second resin layer 30 is covered with the first resin layer 20 or the third resin layer 40 so as to prepare the front surface sealing layer 90. When the material used for the second resin layer 30 is applied or attached to the surface of the third resin layer 40, for example, the second resin layer 30 is then covered with the first resin layer 20. When the material used for the second resin layer 30 is applied or attached to the surface of the first resin layer 20, the second resin layer 30 is then covered with the third resin layer 40. When the solar cell module 100 further includes another layer such as the first barrier layer 80, the first barrier layer 80 may be covered before or after the application or the attachment of the second resin layer 30. Alternatively, the first resin layer 20, the second resin layer 30, and the third resin layer 40 may be bonded together simultaneously in a single step so as to prepare the front surface sealing layer 90.

When at least part of the circumferential edge of the second resin layer 30 is covered, the first resin layer 20 and the third resin layer 40 may be bonded together at the circumferential edge of the second resin layer 30 by heating and pressure bonding, for example.

### <Second stacking step>

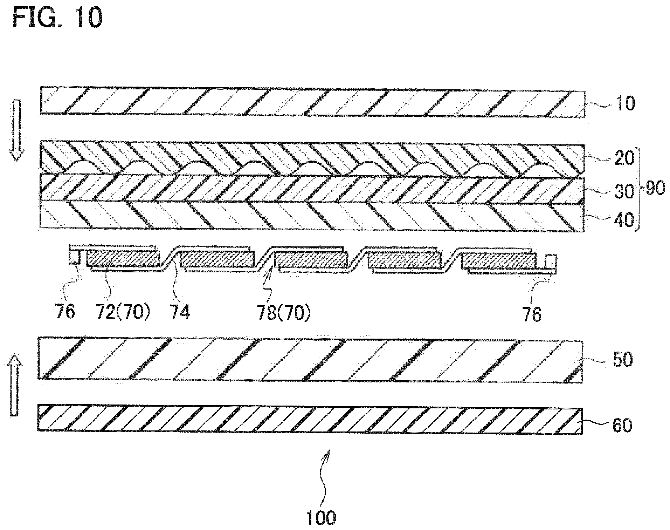

In the second stacking step, as shown in Fig. 10, the front surface protective layer 10, the front surface sealing layer 90 prepared in the first stacking step, the solar cell strings 78 (the photoelectric converter 70), the rear surface sealing layer 50, and the rear surface protective layer 60 are sequentially stacked together from above. The tensile modulus of elasticity smaller for the second resin layer 30 than for the first resin layer 20 and the third resin layer 40 may impede the handling of the second resin layer 30. In view of this problem, the present embodiment includes the process of preparing the front surface sealing layer 90 in the first stacking step, and then stacking the layers including the front surface sealing layer 90, in which the first resin layer 20, the second resin layer 30, and the third resin layer 40 are integrated together, in the second stacking step. The second stacking step, which uses the second resin layer 30 not independently but collectively as the front surface sealing layer 90, can facilitate the handling of the second resin layer 30, and also improve the productivity of the solar cell module 100.

A method of stacking the respective layers in the second stacking step may be determined as appropriate. The second stacking step using the second resin layer 30 not independently but collectively as the front surface sealing layer 90 can facilitate the sequential arrangement and stacking of the respective layers included in the solar cell module 100.

As shown in Fig. 10, the contact area between the second resin layer 30 and the first resin layer 20 in the front surface sealing layer 90 is preferably smaller than the surface area of the second resin layer 30 on the side opposite to the first resin layer 20 in either the first stacking step or the second stacking step. The smaller contact area can facilitate the removal of bubbles through gaps in which the second resin layer 30 and the first resin layer 20 are not in contact during the heating and pressurizing of the respective layers, so as to avoid degradation in appearance caused by the entrance of bubbles. The smaller contact area further buffers a difference in thermal expansion between the first resin layer 20 and the second resin layer 30 at its interface, and allows the first resin layer 20 to easily conform to the second resin layer 30, so as to prevent undulation caused in the second resin layer 30.

The contact area may be smaller than the surface area of the second resin layer 30 on the opposite side at least in the first stacking step or at least in the second stacking step. The contact area may be smaller than the surface area of the second resin layer 30 on the opposite side in both the first stacking step and the second stacking step. The adhesion between the respective layers is preferably sufficiently kept in the following bonding step described below in view of the cross-linking of any material used in the respective layers caused by heating. The contact area is thus preferably smaller than the surface area of the second resin layer 30 on the opposite side at least in the second stacking step or in both the first stacking step and the second stacking step.

The proportion of the contact area between the second resin layer 30 and the first resin layer 20 to the surface area of the second resin layer 30 on the side opposite to the first resin layer 20 is only required to exceed 0%, and may be 20% or greater, or may be 40% or greater. The proportion of the contact area between the second resin layer 30 and the first resin layer 20 to the surface area of the second resin layer 30 on the side opposite to the first resin layer 20 is also only required to be less than 100%, and may be 80% or less, or may be 60% or less.

When the solar cell module 100 is manufactured, undulation tends to be caused in the second resin layer 30 during heating and molding because of a difference in thermal expansion between the first resin layer 20 and the second resin layer 30. The reason for the undulation to be caused is that distortion is caused on the front and rear surfaces due to the curve of the respective layers when the solar cell module 100 to be manufactured has a curved shape. The smaller contact area described above enables the first resin layer 20 to easily follow the expansion deformation of the second resin layer 30 during heating and molding. The solar cell module 100 with less undulation thus can be manufactured regardless of whether the solar cell module 100 has a curved shape.

In order to minimize the contact area between the second resin layer 30 and the first resin layer 30, the first resin layer 20 used in the first stacking step preferably has at least a pattern selected from the group consisting of slits, projections and recesses, and penetration holes. Namely, the first resin layer 20 used in the first stacking step may have slits on the surface, projections and recesses on the surface, penetration holes penetrating from one surface to the other surface, or any combination thereof.

For setting the contact area between the second resin layer 30 and the first resin layer 20 stacked to be smaller, the second resin layer 30 may be stacked on the third resin layer 40 first, and the first resin layer 20 may be then stacked on the surface of the second resin layer 30 so as to prepare the front surface sealing layer 90. Alternatively, the material used for forming the second resin layer 30 may be applied or attached to the surface of the third resin layer 40 first, and the second resin layer 30 may be then covered with the first resin layer 20 so as to prepare the front surface sealing layer 90. These preparing steps can provide a smaller contact area between the second resin layer 30 and the first resin layer 20 to be stacked.

While Fig. 10 illustrates the case in which the first resin layer 20 has projections and recesses, the similar effects can be presumed to be achieved when the third resin layer 40 has projections and recesses. In particular, the contact area between the second resin layer 30 and the third resin layer 40 in the front surface sealing layer 90 is preferably smaller than the surface area of the second resin layer 30 on the side opposite to the third resin layer 40 in at least either the first stacking step or the second stacking step. In addition, the contact area is preferably smaller than the surface area of the second resin layer 30 on the side opposite to the third resin layer 40 at least in the second stacking step or in both the first stacking step and the second stacking step, as in the case in which the first resin layer 20 has projections and recesses.

The proportion of the contact area between the second resin layer 30 and the third resin layer 40 to the surface area of the second resin layer 30 on the side opposite to the third resin layer 40 is only required to exceed 0%, and may be 20% or greater, or may be 40% or greater. The proportion of the contact area between the second resin layer 30 and the third resin layer 40 to the surface area of the second resin layer 30 on the side opposite to the third resin layer 40 is also only required to be less than 100%, and may be 80% or less, or may be 60% or less.

In order to minimize the contact area between the second resin layer 30 and the third resin layer 40, the third resin layer 40 used in the first stacking step preferably has at least a pattern selected from the group consisting of slits, projections and recesses, and penetration holes. Namely, the third resin layer 40 used in the first stacking step may have slits on the surface, projections and recesses on the surface, penetration holes penetrating from one surface to the other surface, or any combination thereof.

For setting the contact area between the second resin layer 30 and the third resin layer 40 stacked to be smaller, the second resin layer 30 may be stacked on the first resin layer 20 first, and the third resin layer 40 may be then stacked on the surface of the second resin layer 30 so as to prepare the front surface sealing layer 90. Alternatively, the material used for forming the second resin layer 30 may be applied or attached to the surface of the first resin layer 20 first, and the second resin layer 30 may be then covered with the third resin layer 40 so as to prepare the front surface sealing layer 90. These preparing steps can provide a smaller contact area between the second resin layer 30 and the third resin layer 40 to be stacked.

### <Bonding step>

In the bonding step, the stacked body obtained in the second stacking step is heated so as to be bonded together. The bonding step may pressurize the stacked body obtained in the second stacking step while heating so as to manufacture the solar cell module 100. The heating conditions are determined as appropriate, and may be set to about 150°C in a vacuum. The heating in a vacuum is preferable since bubbles between the respective layers are easily removed. Alternatively, the respective layers may be heated by a heater, for example, while being pressurized at atmospheric pressure after the heating in a vacuum so as to cross-link a cross-linking component of the material used for forming the respective layers.

The material used for the respective layers could be deformed depending on the conditions such as heating and pressurization. In particular, the pattern selected from the group consisting of slits, projections and recesses, and penetrations holes provided in the first resin layer 20 or the third resin layer 40 before the first stacking step, may be deformed or lost.

As described above, the method of manufacturing the solar cell module 100 according to the present embodiment includes the first stacking step of stacking the first resin layer 20, the second resin layer 30, and the third resin layer 40 to form the front surface sealing layer 90. The method of manufacturing the solar cell module 100 further includes the second stacking step of sequentially stacking the front surface protective layer 10, the front surface sealing layer 90, the photoelectric converter 70, the rear surface sealing layer 50, and the rear surface protective layer 60 together. The method of manufacturing the solar cell module 100 further includes the bonding step of heating and bonding the stacked boy obtained in the second stacking step. The method of manufacturing the solar cell module 100 described above can facilitate the handling of the second resin layer 30, so as to improve the productivity of the solar cell module 100.

### EXAMPLES

Hereinafter, the present embodiment is described in more detail with reference to Examples and Comparative Example, but is not limited to these examples.

### [Example 1]

First, a second resin layer having a thickness of 1 mm was attached to a first resin layer having a thickness of 1 mm. A third resin layer having a thickness of 1 mm was further stacked on the second resin layer, so as to form a front surface sealing layer in which the second resin layer was interposed between the first resin layer and the third resin layer.

Subsequently, a front surface protective layer having a thickness of 1 mm, the front surface sealing layer obtained as described above, a solar cell string, a rear surface sealing layer having a thickness of 1 mm, and a rear surface protective layer having a thickness of 2 mm were sequentially stacked from above so as to prepare a stacked body. The stacked body obtained was then pressurized and heated at 145°C, so as to obtain a solar cell module.

The solar cell string were each obtained such that busbar electrodes on the light-receiving surface side of each of the aligned solar cells were electrically connected to busbar electrodes on the rear side of its adjacent solar cell via connectors made of copper.

The materials used for the respective layers included in the solar cell module are as follows:
Front surface protective layer: polycarbonate (PC), tensile modulus of elasticity of 2.4 GPa
First resin layer: ethylene-vinyl acetate copolymer (EVA), tensile modulus of elasticity of 30.5 MPa
Second resin layer: silicone gel, tensile modulus of elasticity of 28 kPa
Third resin layer: ethylene-vinyl acetate copolymer (EVA), tensile modulus of elasticity of 30.5 MPa
Rear surface sealing layer: ethylene-vinyl acetate copolymer (EVA), tensile modulus of elasticity of 30.5 MPa
Rear surface protective layer: carbon fiber-reinforced plastic (CFRP), tensile modulus of elasticity of 60 GPa

### [Example 2]

A solar cell module of this example was obtained in the same manner as Example 1, except that a barrier layer having a thickness of 0.1 mm was interposed between the second resin layer and the third resin layer.

### [Example 3]

First, a second resin layer having a thickness of 1 mm was attached to a third resin layer having a thickness of 1 mm. Subsequently, a first resin layer having a thickness of 1 mm was then stacked on the second resin layer, so as to prepare a front surface sealing layer in which the second resin layer was interposed between the first resin layer and the third resin layer. The first resin layer, which was provided with projections and recesses on one surface, was stacked on the second resin layer such that the surface provided with the projections and recesses was opposed to the second resin layer. A solar cell module of this example was obtained in the same manner as Example 1 except for the above steps.

### [Comparative Example 1]

A solar cell module of this example was obtained in the same manner as Example 1, except that the first resin layer was not provided. In particular, the front surface protective layer with the thickness of 1 mm, the second resin layer with the thickness of 1 mm, the third resin layer with the thickness of 1 mm, the solar cell string, the rear surface sealing layer with the thickness of 1 mm, and the rear surface protective layer with the thickness of 2 mm were sequentially stacked from above so as to prepare a stacked body. The stacked body obtained was then pressurized and heated at 145°C so as to obtain the solar cell module.

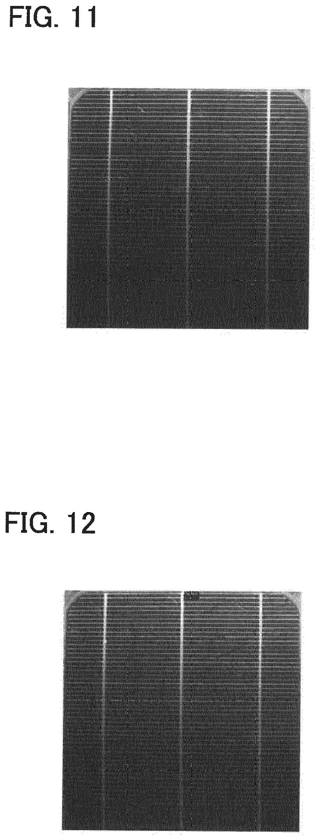

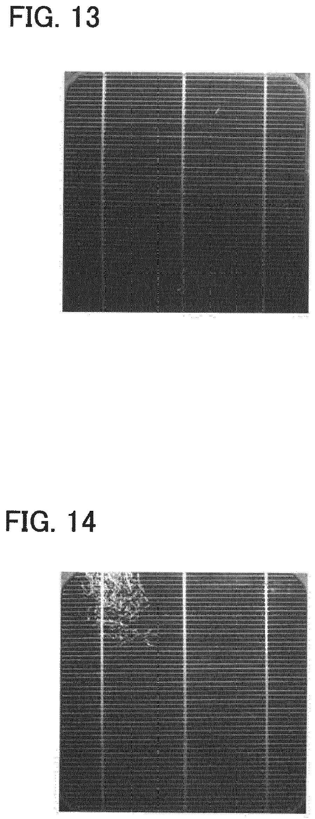

Fig. 11 is a photograph showing the external appearance of the solar cell module obtained in Example 1. Fig. 12 is a photograph showing the external appearance of the solar cell module obtained in Example 2. Fig. 13 is a photograph showing the external appearance of the solar cell module obtained in Example 3. Fig. 14 is a photograph showing the external appearance of the solar cell module obtained in Comparative Example 1. As shown in Fig. 11 to Fig. 13, the solar cell modules of Examples 1 to 3 are prevented from the entrance of bubbles between the respective layers, having good external appearance. The solar cell module of Example 3 particularly has less undulation and better external appearance than the solar cell module of Example 1 or 2. The solar cell module of Comparative Example 1 was provided with bubbles between the front surface protective layer and the second resin layer, as shown in Fig. 14, leading to degradation of external appearance. The results revealed that the solar cell module manufactured such that the second resin layer is first held between the first resin layer and the third resin layer can have good external appearance. The results also revealed that the third resin layer provided with projections and recesses can contribute to avoiding a cause of undulation.

While the present embodiment has been described above by reference to the examples, it should be understood that the present embodiment is not intended to be limited to the above descriptions, and various modifications can be made within the scope of the present embodiment.

## Claims

1. A solar cell module (100) comprising:
a front surface protective layer (10) formed from a resin;
a first resin layer (20) arranged under the front surface protective layer (10);
a second resin layer (30) arranged under the first resin layer (20);
a third resin layer (40) arranged under the second resin layer (30);
a rear surface sealing layer (50) arranged under the third resin layer (40);
a rear surface protective layer (60) arranged under the rear surface sealing layer (50) and formed from a resin; and
a photoelectric converter (70) arranged between the third resin layer (40) and the rear surface sealing layer (50),
the front surface protective layer (10) having a greater tensile modulus of elasticity than the first resin layer (20) and the third resin layer (40),
the second resin layer (30) having a smaller tensile modulus of elasticity than the first resin layer (20) and the third resin layer (40).

2. The solar cell module (100) according to claim 1, wherein the tensile modulus of elasticity of the second resin layer (30) is 0.1 kPa or greater and less than 0.5 MPa.

3. The solar cell module (100) according to claim 1 or 2, wherein the first resin layer (20) has a smaller thickness than the third resin layer (40).

4. The solar cell module (100) according to any one of claims 1 to 3, wherein the first resin layer (20) and the third resin layer (40) are bonded together at least at part of a circumferential edge of the second resin layer (30).

5. The solar cell module (100) according to any one of claims 1 to 4, wherein an entire circumferential edge of the second resin layer (30) is surrounded by the first resin layer (20) and the third resin layer (40).

6. The solar cell module (100) according to any one of claims 1 to 5, wherein the second resin layer (30) is partly in direct contact with the front surface protective layer (10).

7. The solar cell module (100) according to any one of claims 1 to 6, wherein the second resin layer (30) is partly in direct contact with the photoelectric converter (70).

8. The solar cell module (100) according to any one of claims 1 to 7, further comprising a first barrier layer (80) arranged at least on one surface of the second resin layer (30), and having at least either a smaller oxygen transmission rate or a smaller water vapor transmission rate than the front surface protective layer (10).

9. The solar cell module (100) according to any one of claims 1 to 8, further comprising a second barrier layer (85) arranged between the rear surface sealing layer (50) and the rear surface protective layer (60), and having at least either a smaller oxygen transmission rate or a smaller water vapor transmission rate than the rear surface protective layer (60).

10. The solar cell module (100) according to any one of claims 1 to 9, wherein the resin used for the rear surface protective layer (60) is carbon fiber-reinforced plastic.

11. A transport comprising the solar cell module (100) according to any one of claims 1 to 10.

12. A method of manufacturing the solar cell module (100) according to any one of claims 1 to 10, the method comprising:
a first stacking step of stacking the first resin layer (20), the second resin layer (30), and the third resin layer (40) to form a front surface sealing layer (90);
a second stacking step of sequentially stacking the front surface protective layer (10), the front surface sealing layer (90), the photoelectric converter (70), the rear surface sealing layer (50), and the rear surface protective layer (60); and
a bonding step of heating a stacked body of the layers stacked in the second stacking step to bond the respective layers together.

13. The method of manufacturing the solar cell module (100) according to claim 12, wherein a contact area between the second resin layer (30) and the first resin layer (20) in the front surface sealing layer (90) is smaller than a surface area of the second resin layer (30) on a side opposite to the first resin layer (20) in at least either the first stacking step or the second stacking step.

14. The method of manufacturing the solar cell module (100) according to claim 12, wherein a contact area between the second resin layer (30) and the third resin layer (40) in the front surface sealing layer (90) is smaller than a surface area of the second resin layer (30) on a side opposite to the third resin layer (40) in at least either the first stacking step or the second stacking step.
